# FASCICULE DE BREVET EUROPEEN

(11) **EP 1 408 277 B1**
(45) Date de publication et mention de la délivrance du brevet: **01.10.2008**
(21) Numéro de dépôt: 03291634.8
(22) Date de dépôt: 02.07.2003
(51) Int. Cl.: F21V 19/00

(54) **Porte-lampes**
Lampenträger
Lamps holder

(30) Priorité: 30.07.2002 FR 0209681
(43) Date de publication de la demande: 14.04.2004
(73) Titulaire: AUTOMOTIVE LIGHTING REAR LAMPS FRANCE, 89330 Saint-Julien-Du-Sault (FR)
(72) Inventeur: Buisson, Alain, 78320 Le Mesnil Saint Denis (FR)
(74) Mandataire: Faber, Jean-Paul

(56) Documents cités:
- US-A- 3 511 982
- US-B1- 6 411 022
- PATENT ABSTRACTS OF JAPAN vol. 1996, no. 07, 31 juillet 1996 (1996-07-31) & JP 08 064916 A (KOOJIN:KK), 8 mars 1996 (1996-03-08)
- PATENT ABSTRACTS OF JAPAN vol. 1995, no. 06, 31 juillet 1995 (1995-07-31) & JP 07 058422 A (HITACHI CABLE LTD;OTHERS: 01), 3 mars 1995 (1995-03-03)
- PATENT ABSTRACTS OF JAPAN vol. 018, no. 151 (M-1576), 14 mars 1994 (1994-03-14) & JP 05 329876 A (HITACHI CABLE LTD), 14 décembre 1993 (1993-12-14)

## Description

La présente invention vise des porte-lampes plus particulièrement destinés à équiper les véhicules automobiles notamment pour les feux de signalisation.

Jusqu'à maintenant, on réalisait des porte-lampes avec des douilles à vis ou à baïonnettes dans lesquelles des lampes correspondantes pouvaient être montées et changées lorsqu'elles ne fonctionnaient plus.

La technique de fabrication des lampes ayant maintenant évolué, on sait maintenant réaliser des lampes dont la durée d'utilisation est de l'ordre de la durée d'utilisation du véhicule.

La technique antérieure connaît le brevet japonais n° 08 064916 déposé le 24 Juin 1994 qui décrit un panneau de circuit avec des circuits présentant des trous dans lesquels sont engagées des broches de composants, les circuits étant noyés dans un isolant en matière plastique surmoulée.

Une telle disposition ne peut s'appliquer à l'automobile où les différents organes sont soumis à des vibrations. En effet il faut, pour éviter tout faux contact, d'une part, que les lampes soient parfaitement calées dans le porte-lampes et, d'autre part, que les broches soient parfaitement solidarisées avec les plots.

L'invention a pour but de réaliser des porte-lampes destinés à recevoir les lampes de cette nouvelle génération.

selon l'invention, un système d'éclairage destiné à un véhicule automobile ayant une durée d'utilisation comprenant au moins une lampe et un porte lampe est tel que défini à la revendication 1.

On réalise ainsi un porte-lampe ne présentant pas de discontinuité électrique et ayant une grande fiabilité.

Suivant une caractéristique de détail, les circuits découpés comportent des broches destinées à s'étendre dans une jupe réalisée lors du surmoulage et formant un élément de boîtier d'un connecteur destiné à recevoir un élément complémentaire relié à une source de courant pour l'alimentation des différents circuits.

L'invention va maintenant être décrite avec plus de détails en se référant à un mode de réalisation particulier donné à titre d'exemple seulement et représenté aux dessins annexés.
Figure 1 est une vue en perspective d'un circuit découpé destiné à la réalisation d'un porte-lampes.
Figure 2 montre en perspective le porte-lampes réalisé après surmoulage.

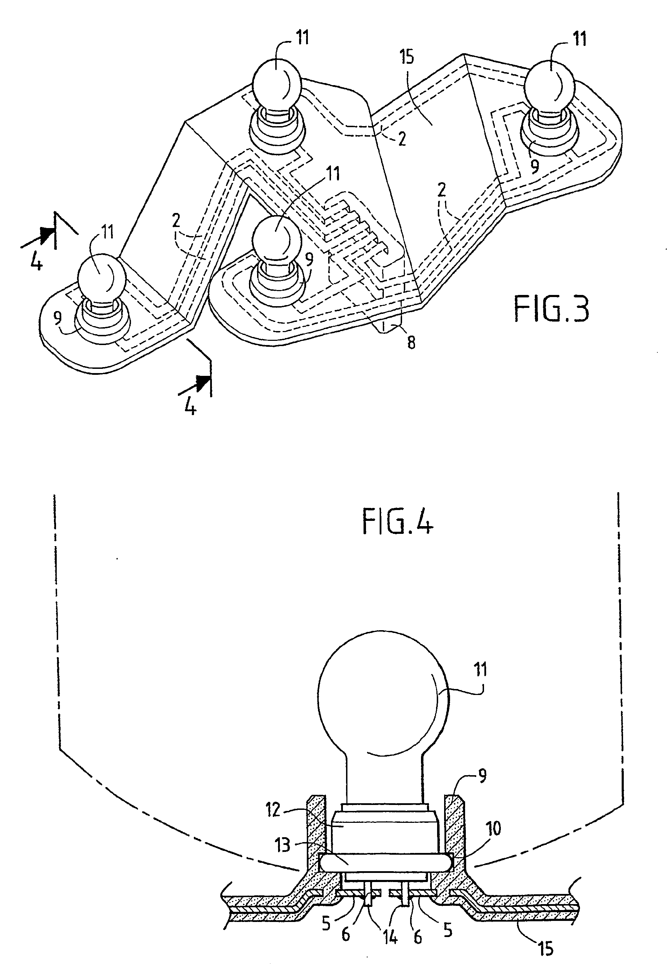

Figure 3 montre le porte-lampes terminé.
Figure 4 est une vue en coupe suivant la ligne 4-4 de la figure 3.

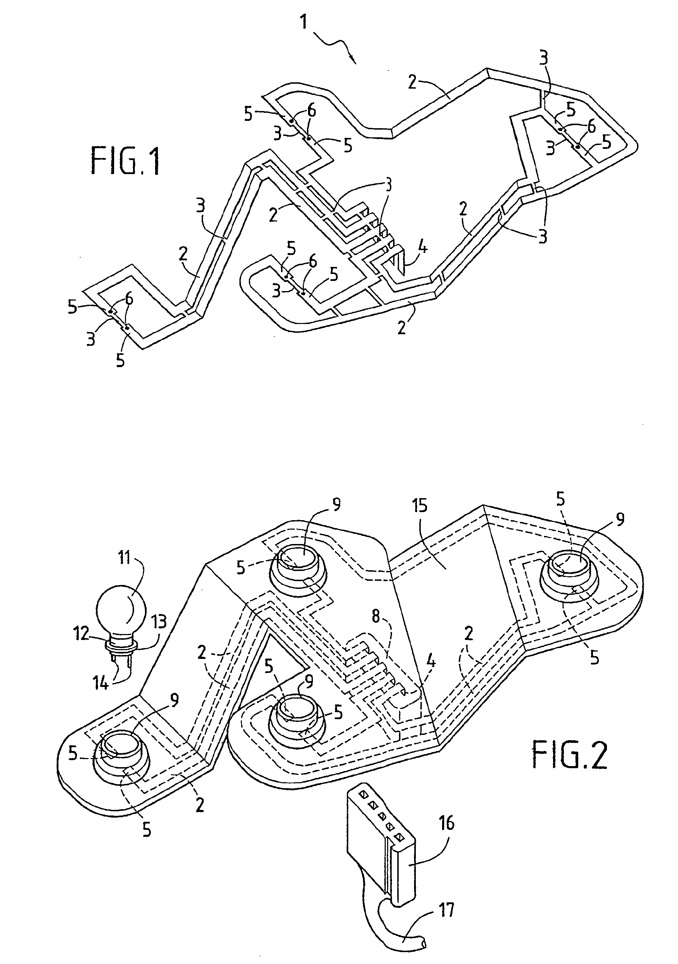

A la figure 1, on a représenté un circuit découpé 1 présentant une série de pistes 2 reliées entre elles par des ponts 3 de manière à former un ensemble destiné à être placé dans un moule, lesdits ponts étant découpés avant l'injection afin de former des circuits indépendants.

Les pistes 2 sont terminées par des parties pliées à angle droit 4 qui sont destinées à constituer des broches pour un connecteur afin d'alimenter les circuits. Les pistes 2 sont*,* du côté opposé aux branches 4, terminées par des plots 5 percés de trous 6.

Le circuit découpé 1 est disposé dans un moule dans lequel, lors de la fermeture ou avant celle-ci, on découpe les ponts 3 avec des outils correspondants puis on procède à une injection de matière plastique afin que les différentes pistes soient noyées dans ladite matière plastique 15 à l'exception des broches 4 autour desquelles est formée une jupe 8 qui constitue l'élément femelle d'un connecteur destiné à recevoir l'élément mâle 16 relié par des conducteurs 17 à une source de courant.

Lors de cette injection, on forme, au droit des plots 5, des douilles 9 ouvertes à chaque extrémité et dans le fond desquelles s'étendent lesdits plots 5.

Les douilles 9 présentent, au voisinage des plots 5, une gorge 10.

Les douilles 9 sont destinées à recevoir des lampes 11 logées dans un culot 12 présentant un bourrelet 13 destiné à s'insérer élastiquement dans la gorge 10, ladite lampe étant terminée par deux broches 14 destinées à traverser les trous 6.

Après montage des lampes 11 et engagement des broches 14 dans les trous 6, celles-ci sont soudées aux plots 5.

Ainsi, on réalise un porte-lampes avec une grande fiabilité du circuit électrique et ne présentant pas de discontinuité électrique.

Bien entendu, l'invention n'est pas limitée au mode de réalisation qui vient d'être décrit et représenté. On pourra y apporter de nombreuses modifications de détail sans sortir pour cela du cadre de l'invention tel que défini par les revendications.

## Revendications

1. Système d'éclairage destiné à un véhicule automobile ayant une durée d'utilisation comprenant au moins une lampe et un porte-lampe du type comprenant des circuits découpés (2) présentant des plots (5) percés, chacun, d'un trou (6) et noyés par surmoulage dans un isolant en matière plastique présentant des douilles (9) destinées à recevoir des lampes (11) pourvues d'un culot (12) présentant un bourrelet périphérique (13), et terminé par deux broches en saillie (14) destinées à être insérées dans les trous (6) des plots (5) situés au droit des douilles (9), **caractérisé en ce que** les douilles (9) présentent une gorge (10) destinée à recevoir le bourrelet périphérique (13) du culot (12) des lampes (11), les broches (14) étant soudées aux plots correspondants, la ou les lampes (11) ayant une durée d'utilisation de l'ordre de la durée d'utilisation du véhicule.

2. Système selon la revendication 1, **caractérisé en ce que** les circuits découpés comportent des broches (4) destinées à s'étendre dans une jupe (8) réalisée lors du surmoulage et formant un élément de boîtier d'un connecteur destiné à recevoir un élément complémentaire relié à une source de courant pour l'alimentation des différents circuits.

## Claims

1. Lighting system for a motor vehicle with long service life comprising at least one lamp and a lamp holder of the type comprising cutout circuits (2) with contact points (5), each pierced with a hole (6) and embedded by moulding into an insulator made of plastic material with sockets (9) for receiving the lamps (11) provided with a lamp base (12) with a peripheral collar (13), and terminated by two projecting pins (14) designed to be inserted into the holes (6) of the contact points (5) situated next to the sockets (9), **characterised in that** the sockets (9) have a recess (10) designed to receive the peripheral collar (13) of the base (12) of the lamps (11), the pins (14) being welded to corresponding contact points, the lamp or lamps (11) having a service life which correlates approximately to the period of use of the vehicle.

2. System according to claim 1, **characterised in that** the cutout circuits comprise pins (4) designed to extend into a skirt (8) formed during the moulding and forming a housing element of a connector designed to receive a complementary element connected to a source of current for supplying different circuits.

## Patentansprüche

1. Beleuchtungssystem für ein Kraftfahrzeug mit einer Nutzungsdauer, das mindestens eine Lampe und einen Lampenträger aufweist, welcher aufgeteilte Stromkreise (2) besitzt, die Buchsen (5) haben, welche jeweils von einem Loch (6) durchbohrt sind, und durch Abformen in einen Isolator aus Kunststoff eingebettet sind, welcher Fassungen (9) zur Aufnahme der Lampen aufweist, die mit einem Sockel (12) versehen sind, der einen umlaufenden Wulst (13) besitzt, und in zwei vorstehenden Stiften (14) endet, die in die Löcher (6) der Buchsen (5) eingesteckt werden, welche sich im rechten Winkel zu den Fassungen (9) befinden, **dadurch gekennzeichnet, dass** die Fassungen (9) eine Kehle (10) aufweisen, die den umlaufenden Wulst (13) des Sockels der Lampen (11) aufnimmt, wobei die Stifte (14) an die entsprechenden Buchsen (5) angeschweißt sind, und die Lampe oder die Lampen (11) eine Nutzungsdauer in der Größenordnung der Nutzungsdauer des Kraftfahrzeuges besitzen.

2. System nach Anspruch 1, **dadurch gekennzeichnet, dass** die aufgeteilten Stromkreise Stifte (4) besitzen, die in eine Art Schürze (8) hinein verlaufen, welche während des Abformens hergestellt wird, und die ein Gehäuseelement für einen Verbinder bildet, welcher ein zusätzliches Element aufnimmt, das mit einer Stromquelle verbunden ist, um die verschiedenen Stromkreise zu versorgen.
